(19) Europäisches Patentamt / European Patent Office / Office européen des brevets

(11) **EP 4 332 593 B1**

(12) **EUROPEAN PATENT SPECIFICATION**

(45) Date of publication and mention
of the grant of the patent:
**03.06.2026 Bulletin 2026/23**

(21) Application number: **22207245.6**

(22) Date of filing: **14.11.2022**

(51) International Patent Classification (IPC):
**G01R 31/34** (2020.01)        **H02M 1/08** (2006.01)
**H02M 1/00** (2006.01)        **H02M 7/162** (2006.01)

(52) Cooperative Patent Classification (CPC):
**G01R 31/34; H02M 1/0009; H02M 7/1626;**
**H02M 1/081**

(54) **EXCITATION CIRCUIT, EXCITATION SMALL-CURRENT TEST METHOD AND ELECTRONIC DEVICE**

ERREGUNGSSCHALTUNG, SCHWACHSTROM-ERREGUNGSTESTVERFAHREN UND ELEKTRONISCHE VORRICHTUNG

CIRCUIT D'EXCITATION, PROCÉDÉ DE TEST DE FAIBLE COURANT D'EXCITATION ET DISPOSITIF ÉLECTRONIQUE

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**

(30) Priority: **31.08.2022 CN 202211068301**

(43) Date of publication of application:
**06.03.2024 Bulletin 2024/10**

(73) Proprietor: **China Three Gorges Co., Ltd.**
**Wuhan Hubei 430010 (CN)**

(72) Inventors:
• **LIU, Xiquan**
**Wuhan, 430010 (CN)**
• **WANG, Liangyou**
**Wuhan, 430010 (CN)**
• **SUN, Changping**
**Wuhan, 430010 (CN)**
• **LEI, Xiao**
**Wuhan, 430010 (CN)**
• **LE, Bo**
**Wuhan, 430010 (CN)**
• **LI, Wei**
**Wuhan, 430010 (CN)**
• **LI, Peng**
**Wuhan, 430010 (CN)**
• **FU, Guangze**
**Wuhan, 430010 (CN)**

(74) Representative: **J A Kemp LLP**
**80 Turnmill Street**
**London EC1M 5QU (GB)**

(56) References cited:
CN-A- 106 814 315        CN-A- 109 581 176
CN-U- 209 764 962        CN-U- 214 375 065
CN-U- 214 409 220

• KUTSYK ANDRIY ET AL: "Diagnosis of the Static Excitation Systems of Synchronous Generators with the Use of Hardware-In-the-Loop Technologies", ENERGIES, vol. 14, no. 21, 21 October 2021 (2021-10-21), pages 6937, XP093075279, DOI: 10.3390/en14216937

**Description**

## TECHNICAL FIELD

The invention relates to the technical field of overhaul of power generation device, in particular to an excitation circuit, an excitation small-current test method and an electronic device.

## BACKGROUND TECHNIQUE

The article "Diagnosis of the Static Excitation Systems of Synchronous Generators with the Use of Hardware-In-the-Loop Technologies" by Andriy Kutsyk et al from Energies 2021, 14, 6937 discloses various ways to solve the problem of generator self-excitation in a static excitation system. CN 214409220 U discloses a test system for excitation small current test. CN 214375065 U discloses an open-loop small-current testing device for a large-scale generator excitation system. CN 209764962 U discloses a test device for excitation system control and rectification loop function verification. CN 109581176 A discloses a method for testing a small current of thyristors and pulse trigger loops thereof. CN 106814315 A discloses an excitation system integral tester.

As the core control equipment of the generator, the excitation system of the synchronous generator provides the generator with an electromagnetic field through the rectifier bridge, generates electric energy, and maintains the stability of the generator voltage and reactive power. However, a rectification fault occurs in the excitation system of the generator. When analyzing and dealing with the fault, it is necessary to test and verify the excitation small-current test.

The excitation small-current test means that the generator is in a static state. By applying an anode power supply to the anode side of the excitation system rectifier bridge and applying a small resistive load to the DC side, the excitation system is in the open-loop fixed-angle control mode, and the excitation regulator is checked and verified. The synchronization, phase shifting, triggering and triggering performance of thyristor rectifier bridges. After using an oscilloscope to display relevant test data in the existing excitation small-current test process, it needs to be calculated manually according to the displayed data, which is inefficient and complicated in the calculation process, which often leads to test failure.

## SUMMARY OF THE INVENTION

In view of this, the embodiments of the present invention provide an excitation circuit, an excitation small-current test method and an electronic device, so as to solve the technical problem that manual calculation is required after obtaining relevant test data in the excitation small-current test process in the prior art, involving low efficiency and complex computation that often lead to test failures.

The technical schemes proposed by the invention are as follows:

In the first aspect, an embodiment of the invention provides an excitation circuit, which includes a test power supply, an excitation small-current tester, a thyristor rectifier bridge, and an excitation regulator; one end of the excitation regulator is connected to a first pin of the thyristor rectifier bridge for sending a synchronization signal to the thyristor rectifier bridge, the synchronization signal is used for triggering a pulse signal of the thyristor rectifier bridge; the other end of the excitation regulator is connected to the excitation small-current tester for receiving a PT voltage signal sent by the excitation small-current tester, and the PT voltage signal is used for judging whether the excitation regulator is operating normally; the test power supply is connected to the excitation small-current tester for outputting a voltage signal to the excitation small-current tester; the excitation small-current tester includes a switch, a voltage regulator, a current transformer, a voltage transformer, an industrial controller, an oscilloscope, a resistive load and a shunt; wherein, a first pin of the current transformer is connected to a second pin of the thyristor rectifier bridge for receiving the anode three-phase current output from the thyristor rectifier bridge; a first pin of the voltage transformer is connected through the current transformer to the second pin of the thyristor rectifier bridge for receiving the anode three-phase voltage output from the thyristor rectifier bridge; an input end of the oscilloscope is connected to a third pin of the thyristor rectifier bridge through the resistive load and the shunt for displaying an excitation current and an excitation voltage output from the thyristor rectifier bridge; a first pin of the industrial controller is connected to a second pin of the current transformer for receiving the anode three-phase current sent by the current transformer; a second pin of the industrial controller is connected to a second pin of the voltage transformer for receiving the anode three-phase voltage sent by the voltage transformer; a third pin of the industrial controller is connected to the output end of the oscilloscope for receiving the excitation current and the excitation voltage sent by the oscilloscope.

Optionally, in a possible implementation of the first aspect, the other end of the excitation regulator is further connected to the second pin of the thyristor rectifier bridge.

Optionally, in a possible implementation of the first aspect, a third pin of the current transformer is connected to the test power supply through the voltage regulator and the switch; and the first pin of the voltage transformer is further connected to the test power supply through the voltage regulator and the switch.

Optionally, in a possible implementation of the first aspect, the oscilloscope is further configured to display a six-pulse waveform of the thyristor rectifier bridge; the industrial controller is further configured to display the six-pulse waveform of the thyristor rectifier bridge sent by the oscilloscope; and the industrial controller is further configured to display an output waveform of the thyristor rectifier bridge, and the output waveform includes an anode three-phase voltage waveform, an excitation current waveform, an excitation voltage waveform and an anode three-phase current waveform.

In the second aspect, an embodiment of the present invention provides an excitation small-current test method, which is applied to the excitation circuit according to the first aspect of the embodiment of the present invention and any one of the possible implementations of the first aspect, and the excitation small-current test method includes acquiring the anode three-phase voltage and the excitation voltage of the thyristor rectifier bridge when the excitation small-current tester receives the voltage signal output from the test power supply and determines a first control angle of the excitation regulator, wherein the first control angle is used for controlling the thyristor rectifier bridge to switch into conduction; calculating a second control angle of the thyristor rectifier bridge by a preset algorithm based on the first control angle, the anode three-phase voltage and the excitation voltage, wherein the second control angle is a control angle of the thyristor rectifier bridge when the excitation regulator controls the thyristor rectifier bridge to switch into conduction based on the first control angle, and the second control angle is used for controlling the thyristor rectifier bridge to be kept in a rectifying state; analyzing the accuracy of the regulating performance of the field regulator based on the first control angle and the second control angle.

Optionally, in a possible implementation of the second aspect, the method further includes acquiring the anode three-phase current and the excitation current of the thyristor rectifier bridge when the excitation small-current tester receives the voltage signal output from the test power supply and determines a first control angle of the excitation regulator; and generating an excitation small-current test report based on the anode three-phase voltage, the excitation voltage, the anode three-phase current and the excitation current.

Optionally, in a possible implementation of the second aspect, the method further includes calling a preset knowledge base for diagnosis to obtain a first diagnosis result when a six-pulse waveform of the thyristor rectifier bridge is displayed incompletely, wherein the first diagnosis result includes one or more of an abnormality of a thyristor of the thyristor rectifier bridge, an abnormality of a pulse trigger signal of the thyristor rectifier bridge, and an abnormality of a pulse transformer of the thyristor rectifier bridge, and the preset knowledge base includes a voltage calculation method, a current calculation method, expert knowledge and a logic judgment method.

Optionally, in a possible implementation of the second aspect, the method further includes calling a preset knowledge base for diagnosis to obtain a second diagnosis result when an output waveform of the thyristor rectifier bridge is abnormally displayed or not displayed, wherein the second diagnosis result includes one or more of a wiring phase sequence error of the test power supply, an abnormality of the test power supply, and an insufficient capacity of the test power supply.

Optionally, in a possible implementation of the second aspect, the method further includes calling a preset knowledge base for diagnosis to obtain a third diagnosis result when the first control angle is inconsistent with the second control angle, wherein the third diagnosis result is that a sampling signal of a synchronous transformer in the excitation regulator is inconsistent with actual working wiring.

In a third aspect, an embodiment of the present invention provides an electronic device comprising a memory and a processor, wherein the memory and the processor are connected in communication with each other, the memory stores computer instructions, and the processor is configured to execute the excitation small-current test method according to the second aspect of the embodiment of the present invention and any one of the possible implementations of the second aspect by executing the computer instructions.

The technical schemes provided by the invention have the following effects:

In the excitation circuit provided by the embodiments of this application, an industrial controller is added to the excitation small-current tester, which reduces the wiring complexity of the excitation current test, and can display the anode three-phase voltage, the anode three-phase current, the excitation current and the excitation voltage of the thyristor rectifier bridge that are received; and by using these data, the industrial controller can directly complete the relevant calculation in the excitation current test process, which improves the efficiency and reduces the complexity of the calculation process.

The excitation small-current test method provided by the embodiment of the present invention is applied to the excitation circuit, the thyristor rectifier bridge is controlled by adjusting the control angle of the excitation regulator to switch into conduction. Moreover, when the industrial controller receives the anode three-phase voltage and excitation voltage of the thyristor rectifier bridge, the industrial controller can directly use a built-in preset algorithm to calculate without manual calculation, which improves the efficiency and reduces the complexity of the calculation process.

## BRIEF DESCRIPTION OF THE DRAWINGS

To more clearly illustrate the specific embodiments of this application or the technical solutions in the prior art, the accompanying drawings that are required for describing the specific embodiments or the prior art will be explained briefly below. Obviously, the accompanying drawings described below are some embodiments of this application. A person of ordinary skill in the art may further obtain other accompanying drawings based on the accompanying drawings without creative efforts.

FIG. 1 is a schematic structural diagram of an excitation circuit according to an embodiment of the present application;
FIG. 2 is a flowchart of an excitation small-current test method according to an embodiment of the present application;
FIG. 3 is a schematic structural diagram of a computer-readable storage medium provided according to an embodiment of the present application;
FIG. 4 is a schematic structural diagram of an electronic device provided according to an embodiment of the present application.

## DETAILED DESCRIPTION

Technical solutions of this application are clearly and completely described below with reference to the accompanying drawings. Obviously, the described embodiments are some, but not all, of the embodiments of this application. Based on the embodiments of this application, all other embodiments obtained by a person of ordinary skill in the art without making creative efforts shall fall within the protection scope of this application.

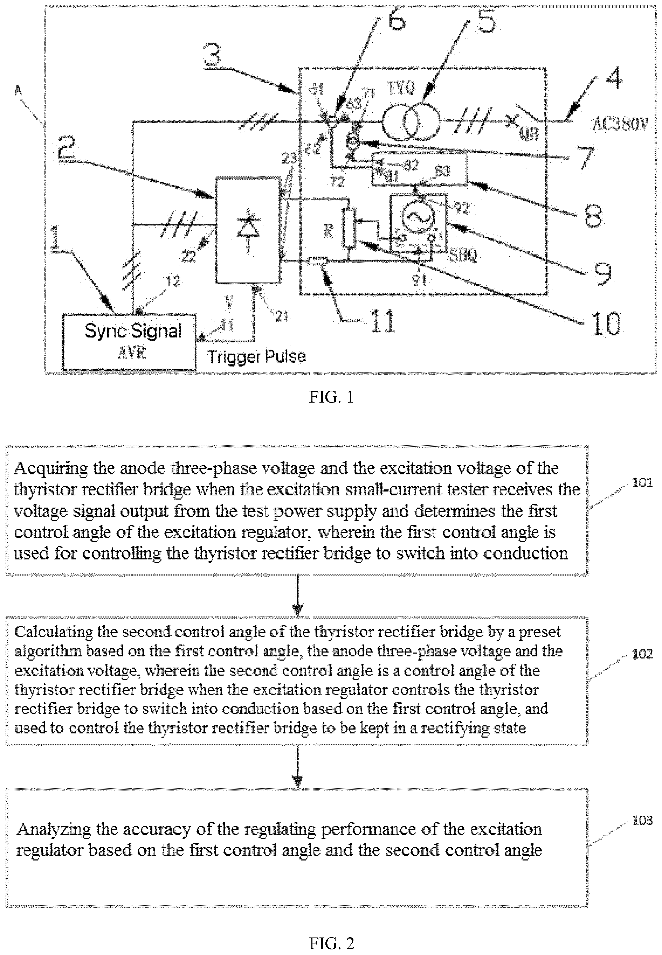

An embodiment of this application provides an excitation circuit, as shown in FIG. 1. The excitation circuit (A) includes: a test power supply (4), an excitation small-current tester (3), a thyristor rectifier bridge (2) and an excitation regulator (1).

Specifically, the test power supply (4) may be an AC380V test power supply, which is configured to provide the excitation small-current tester (3) with the voltage required for the test;

The excitation small-current tester (3) is configured to complete the excitation small-current test in the excitation circuit. Among them, the excitation small-current test check the basic control function, the ability to reliably trigger the pulse, the integrity of the thyristor of the excitation regulator (1) by creating a simulated environment etc., check the phase sequence and phase of the synchronous signal loop in order to see whether the pulse trigger of the excitation regulator (1) is correct; check the output waveform of the thyristor, etc.

The rectifier bridge generally has a large inductive load to make sure there will be no current interruption. Therefore, the thyristor rectifier bridge (2) means that there is also a sufficiently large inductive load in the thyristor.

The excitation regulator (1) can adjust the excitation, thereby adjusting the magnitude and direction of the voltage.

The specific connection method is:

One end (11) of the excitation regulator (1) is connected to the first pin (21) of the thyristor rectifier bridge (2) for sending a synchronization signal to the thyristor rectifier bridge (2), the synchronization signal is used for triggering the pulse signal of the thyristor rectifier bridge (2); the other end (12) of the excitation regulator is connected to the excitation small-current tester (3) for receiving the PT voltage signal sent by the excitation small-current tester (3), the PT voltage signal is used for judging whether the excitation regulator (1) is operating normally; the test power supply (4) is connected to the excitation small-current tester (3) for outputting a voltage signal to the excitation small-current tester (3).

Specifically, the synchronization signal is the timing zero point of the control pulse signal, which is generally consistent with the natural commutation point of the thyristor rectifier bridge (2) or has a fixed phase difference;

In the excitation small-current test, the PT voltage signal is sent to the excitation regulator (1) so that the excitation regulator can work normally. It will judge that the excitation fails if the excitation regulator cannot receive the PT voltage signal;

Preferably, the excitation small-current tester (3) includes a switch (QB), a voltage regulator (5), a current transformer (6), a voltage transformer (7), an industrial controller (8), an oscilloscope (9), a resistive load (10) and a shunt (11);

Wherein, the first pin (61) of the current transformer (6) is connected to the second pin (22) of the thyristor rectifier bridge (2) for receiving the anode three-phase current output from the thyristor rectifier bridge (2); the first pin (71) of the voltage transformer (7) is connected to the second pin (22) of the thyristor rectifier bridge (2) for receiving the anode three-phase voltage output of the thyristor rectifier bridge (2); the input end (91) of the oscilloscope (9) is connected to the third pin (23) of the thyristor rectifier bridge (2) through the resistive load (10) and the shunt (11) for displaying the excitation current and excitation voltage output from the thyristor rectifier bridge (2).

Specifically, the voltage regulator (5) is configured to reduce the voltage of the test power supply (4) to AC100V; the current transformer (6) represents an instrument that converts a large current on the primary side into a small current on the secondary side to measure according to the principle of electromagnetic induction, playing the role of current transformation and electrical isolation; in the excitation small-current test, the anode three-phase current of the thyristor rectifier bridge (2) can be sampled; the voltage transformer (7) represents the instrument used to change the voltage; in the excitation small-current test, the anode three-phase voltage of the thyristor rectifier bridge (2) can be sampled; the industrial controller (8) is the control, intelligent diagnosis and display device of the excitation small-current tester (3) in the excitation small-current test; the oscilloscope (9) is an electronic measuring instrument that can convert electrical signals into images, which is convenient for studying the changing process of various electrical phenomena; in the excitation small-current test, it can be used for the measurement and output display of the output waveform of the thyristor rectifier bridge (2); the resistive load (10) can absorb the unnecessary electricity generated during the test use, or play the role of buffering and braking; in the excitation small-current test, it is configured to output the corresponding resistive load of the thyristor rectifier bridge (2); the shunt (11) represents an instrument for measuring DC current, in the excitation small-current test, it represents the excitation current sampling sensor output from the thyristor rectifier bridge (2), that is to shunt the sampling of the excitation current output from the thyristor rectifier bridge (2).

Through the excitation current of the thyristor rectifier bridge (2) sampled by the shunt (11) and the resistive load of the thyristor rectifier bridge (2) output from the resistive load (10), the excitation voltage of the thyristor rectifier bridge (2) can be obtained. Therefore, after the third pin (23) of the thyristor rectifier bridge (2) is connected to the oscilloscope (9) through the resistive load (10) and the shunt (11), the oscilloscope (9) can display the thyristor rectifier bridge (2) output excitation voltage.

Also included are: the first pin (81) of the industrial controller (8) is connected to the second pin (62) of the current transformer (6) for receiving the anode three-phase current sent by the current transformer (6); the second pin (82) of the industrial controller (8) is connected to the second pin (72) of the voltage transformer (7) for receiving the anode three-phase voltage sent by the voltage transformer (7); the third pin (83) of the industrial controller (8) is connected to the output end (92) of the oscilloscope (9) for receiving the excitation current and the excitation voltage.

Specifically, after the anode three-phase current of the thyristor rectifier bridge (2) is sampled by the current transformer (6), it is output through the second pin (62) and input into the corresponding industrial controller (8) through the first pin (81) of the industrial controller (8).

After the anode three-phase voltage of the thyristor rectifier bridge (2) is sampled by the voltage transformer (7), it is output through the second pin (72) and input into the corresponding industrial controller (8) through the second pin (82) of the industrial controller (8);

After the excitation voltage and excitation current output from the thyristor rectifier bridge (2) are received by the oscilloscope (9), they are output through the output end (92) and input into the corresponding industrial controller (8) through the third pin (83) of the industrial controller (8).

In the excitation circuit provided by the embodiments of this application, an industrial controller is added to the excitation small-current tester, which reduces the wiring complexity of the excitation current test, and can display the anode three-phase voltage, the anode three-phase current, the excitation current and the excitation voltage of the thyristor rectifier bridge that are received; and by using these data, the industrial controller can directly complete the relevant calculation in the excitation current test process, which improves the efficiency and reduces the complexity of the calculation process.

As an optional implementation of the embodiment of the present invention, the other end (12) of the excitation regulator (1) is further connected to the second pin (22) of the thyristor rectifier bridge (2).

Specifically, one end (11) of the excitation regulator (1) is connected to the first pin (21) of the thyristor rectifier bridge (2), and the other end (12) is connected to the second pin (22) of the thyristor rectifier bridge (2). Such a connection manner enables to form a closed-loop circuit so as to better control the thyristor rectifier bridge (2) to switch into conduction.

As an optional implementation of the embodiment of the present invention, the third pin (63) of the current transformer (6) is connected to the test power supply (4) through the voltage regulator (5) and the switch (QB); the first pin (71) of the voltage transformer (7) is also connected to the test power supply (4) through the voltage regulator (5) and the switch (QB).

Specifically, the current transformer (6) and the voltage transformer (7) are respectively connected to the test power supply (4) for receiving the voltage signal sent by the test power supply (4) to start running.

As an optional implementation of the embodiment of the present invention, the oscilloscope (9) is further configured to display the six-pulse waveform of the thyristor rectifier bridge (2); the industrial controller (8) is further configured to display the six-pulse waveform of the thyristor rectifier bridge (2) sent by the oscilloscope (9); the industrial controller (8) is further configured to display an output waveform of the thyristor rectifier bridge (2), the output waveform including an anode three-phase voltage waveform, an excitation current waveform, an excitation voltage waveform and an anode three-phase current waveform.

Specifically, a thyristor rectifier bridge (2) is composed of six thyristors, and the six thyristors will be switched into conduction separately within one cycle of 20 ms, so when these six thyristors are triggered, six pulses will be sent correspondingly, and the waveform of the corresponding six-pulse wave will be displayed when the six pulses are output from the thyristor rectifier bridge (2), that is, the six-pulse waveform. After the six-pulse waveform is received by the oscilloscope (9), it is transmitted to the industrial controller (8) connected therewith for display.

Similarly, the industrial controller (8) will respectively form and display corresponding waveforms according to the received anode three-phase voltage, excitation current, excitation voltage and anode three-phase current output from the thyristor rectifier bridge (2).

The embodiment of this application provides an excitation small-current test method, which is applied to the excitation circuit (A) according to the embodiment of this application.

Specifically, before conducting the excitation small-current test, the AC side of the thyristor rectifier bridge (2) is disconnected from the excitation regulator (1) and the DC side of the thyristor rectifier bridge (2) is disconnected from the rotor side.

As shown in FIG. 2, the excitation small-current test method includes the following steps:

Step 101: acquiring the anode three-phase voltage and the excitation voltage of the thyristor rectifier bridge when the excitation small-current tester receives the voltage signal output from the test power supply and determines a first control angle of the excitation regulator, wherein the first control angle is used for controlling the thyristor rectifier bridge to switch into conduction.

Specifically, when the excitation small-current test is started, the connection between the test power supply (4) and the excitation small-current tester (3) is completed, the voltage signal is transmitted to the excitation small-current tester (3) so that the excitation small-current tester (3) starts running.

The excitation regulator (1) is set to a control angle mode, the "start excitation" button and then the magnetization button are clicked to adjust the first control angle from an inverter angle to the waveforms of 90°, 60° and 30° respectively, and the anode three-phase voltage and excitation voltage of the thyristor rectifier bridge (2) corresponding to different control angles are thus obtained. Wherein, when the thyristor rectifier bridge (2) is controlled into conduction by different control angles, different anode three-phase voltages and excitation voltages are generated.

Step 102: calculating a second control angle of the thyristor rectifier bridge by a preset algorithm based on the first control angle, the anode three-phase voltage and the excitation voltage, wherein the second control angle is a control angle of the thyristor rectifier bridge when the excitation regulator controls the thyristor rectifier bridge to switch into conduction based on the first control angle, and the second control angle is used to control the thyristor rectifier bridge to be kept in a rectifying state.

Specifically, when the first control angle is less than 60°, the second control angle is calculated according to formula (1):

$$\mathrm{U_d} = 1.35\mathrm{U_2}\cos\alpha \qquad (1)$$

In the formula: $U_d$ represents the excitation voltage; $U_2$ represents the anode three-phase voltage; and $\alpha$ represents the second control angle;

When the first control angle is greater than 60°, the second control angle is calculated according to formula (2):

$$U_d = 1.35 U_2 \left[ 1 + cos\left(\frac{\pi}{3} + \alpha\right) \right] \qquad (2)$$

In the formula: $U_d$ represents the excitation voltage; $U_2$ represents the anode three-phase voltage; and $\alpha$ represents the second control angle.

Step 103: analyzing the accuracy of the regulating performance of the excitation regulator based on the first control angle and the second control angle.

Specifically, the second control angle represents the control angle of the thyristor rectifier bridge (2) when the excitation regulator (1) controls the thyristor rectifier bridge (2) in the state of the first control angle to switch into conduction. Therefore, by comparing the first control angle with the second control angle, the accuracy of the control angle of the excitation regulator (1) can be checked, thus analyzing the accuracy of the adjustment performance of the excitation regulator.

The excitation small-current test method provided by the embodiment of this application is applied to the excitation circuit, and the thyristor rectifier bridge is controlled by adjusting the control angle of the excitation regulator to switch into conduction. Moreover, when the industrial controller receives the anode three-phase voltage and excitation voltage of the thyristor rectifier bridge, the industrial controller can directly use a built-in preset algorithm to calculate without manual calculation, which improves the efficiency and reduces the complexity of the calculation process.

As an optional implementation of the embodiment of this application, the method further includes acquiring the anode three-phase current and the excitation current of the thyristor rectifier bridge when the excitation small-current tester receives the voltage signal output from the test power supply and determines the first control angle of the excitation regulator; and generating a excitation small-current test report based on the anode three-phase voltage, the excitation voltage, the anode three-phase current and the excitation current.

Specifically, after the excitation small-current tester (3) starts the test, the anode three-phase current and excitation current of the corresponding thyristor rectifier bridge (2) can also be obtained according to the first control angle of the excitation regulator (1). For the specific implementation process, reference may be made to the specific connection of the excitation circuit and the functional description of each element in the circuit provided in the embodiment of this application, which will not be repeated here.

The industrial controller (8) generates an excitation small-current test report according to the received anode three-phase voltage, excitation voltage, anode three-phase current and excitation current of the thyristor rectifier bridge (2), which is convenient for subsequent viewing.

As an optional implementation of the embodiment of this application, the method further includes calling a preset knowledge base for diagnosis to obtain a first diagnosis result when a six-pulse waveform of the thyristor rectifier bridge is displayed incompletely, wherein the first diagnosis result includes one or more of an abnormality of a thyristor of the thyristor rectifier bridge, an abnormality of a pulse trigger signal of the thyristor rectifier bridge, and an abnormality of a pulse transformer of the thyristor rectifier bridge, and the preset knowledge base includes a voltage calculation method, a current calculation method, expert knowledge, and a logic judgment method.

Wherein, the pulse transformer is arranged inside the thyristor rectifier bridge (2), which can be used to reduce the pulse voltage and increase the output trigger current, and can also electrically isolate the trigger circuit from the main circuit, which is safe and prevents interference, Moreover, pulse distribution can be performed by multiple secondary windings of the pulse transformer to achieve the purpose of triggering multiple thyristors in the thyristor rectifier bridge (2) at the same time.

Specifically, a knowledge base is preset in the industrial controller (8), including a voltage calculation method, a current calculation method, expert knowledge, and a logic judgment method. Through these methods, the industrial controller (8) can also perform self-diagnosis of test abnormalities during the excitation small-current test process.

According to the knowledge base, when the six-pulse waveform of the thyristor rectifier bridge (2) is displayed incompletely, it means that one or more of an abnormality of the thyristor of the thyristor rectifier bridge, an abnormality of the pulse trigger signal of the thyristor rectifier bridge, or an abnormality of the pulse transformer of the thyristor rectifier bridge may occur during the excitation small-current test process.

After the industrial controller (8) displays the diagnosis result, the user can further determine the final fault problem by checking the pulse transformer, or checking the pulse trigger circuit, or checking the thyristor rectifier bridge (2). Wherein, the pulse trigger loop is formed by connecting the excitation regulator (1) and the thyristor rectifier bridge (2).

As an optional implementation of the embodiment of the present invention, the method further includes calling a preset knowledge base for diagnosis to obtain a second diagnosis result when an output waveform of the thyristor rectifier bridge is abnormally displayed or not displayed, wherein the second diagnosis result includes one or more of a wiring phase sequence error of the test power supply, an abnormality of the test power supply, and an insufficient capacity of the test power supply.

Specifically, according to the excitation circuit provided by the embodiment of the present invention, the output waveform of the thyristor rectifier bridge includes an anode three-phase voltage waveform, an excitation current waveform, an excitation voltage waveform and an anode three-phase current waveform.

According to the knowledge base, when the output waveform of the thyristor rectifier bridge (2) is displayed abnormally or not displayed, it means that a wiring phase sequence error of the test power supply (4) or an abnormality of the test power supply (4) may occur during the excitation small-current test process. Wherein, if the anode three-phase voltage waveform is abnormal, it means that the capacity of the test power supply (4) may be insufficient during the excitation small-current test process.

If a wiring phase sequence error of the test power supply (4) or an abnormality of the test power supply (4) occurs, the user can further determine the final fault problem by checking the wiring and voltage of the test power supply (4);

If a wiring phase sequence error of the test power supply (4) occurs or the capacity of the test power supply (4) is insufficient, the user can further determine the final fault problem by checking the wiring and power of the test power supply (4).

As an optional implementation of the embodiment of this application, the method further includes calling the preset knowledge base for diagnosis to obtain a third diagnosis result when the first control angle is inconsistent with the second control angle, wherein the third diagnosis result is that the sampling signal of the synchronous transformer in the excitation regulator is inconsistent with the actual working wiring.

Specifically, the synchronous transformer in the excitation regulator (1) is configured to provide a synchronous signal for the thyristor rectifier bridge (2).

According to the knowledge base, when the first control angle is inconsistent with the second control angle, it means that the sampling signal of the synchronous transformer in the excitation regulator may be inconsistent with the actual working wiring during the excitation small-current test process. At this time, according to the diagnosis result displayed by the industrial controller (8), the user can determine the final fault diagnosis condition from the wiring condition of the synchronous transformer.

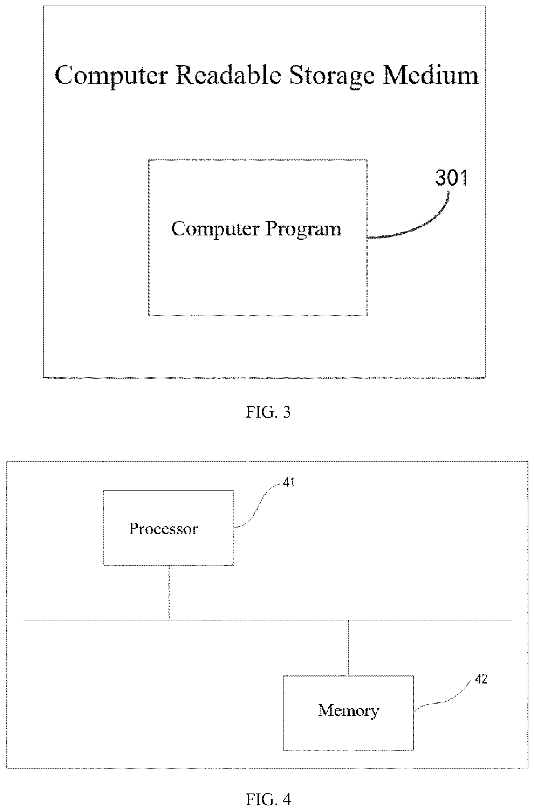

An embodiment of this application further provides a storage medium, as shown in FIG. 3, on which a computer program 301 is stored, and when the instruction is executed by a processor, the steps of the excitation small-current test method in the foregoing embodiments are implemented. Wherein, the storage medium may be a magnetic disk, an optical disk, a Read-Only Memory (ROM), a Random Access Memory (RAM), a Flash Memory, a Hard Disk Drive (HDD), or a Solid-State Drive (SSD), etc.; the storage medium may also include a combination of the memories mentioned above.

Those skilled in the art can understand that the realization of all or part of the processes in the methods of the above embodiments can be completed by instructing the relevant hardwares by a computer program. The program can be stored in a computer-readable storage medium, and when the program is executed, the processes of the methods in the above embodiments are included. Wherein, the storage medium may be a magnetic disk, an optical disk, a Read-Only Memory (ROM), a Random Access Memory (RAM), a Flash Memory, a Hard Disk Drive (HDD), or a Solid-State Drive (SSD), etc.; the storage medium may also include a combination of the memories mentioned above.

The embodiment of this application further provides an electronic device, as shown in FIG. 4. The electronic device may include a processor 41 and a memory 42, wherein the processor 41 and the memory 42 may be connected through a bus or in other ways, and the connection through a bus is taken as an example in FIG. 4.

The processor 41 may be a Central Processing Unit (CPU). The processor 41 may also be other general-purpose processors, Digital Signal Processor (DSP), Application Specific Integrated Circuit (ASIC), Field-Programmable Gate Array (FPGA) or other programmable logic devices, discrete gates or transistor logic devices, discrete hardware components and other chips, or a combination of the above types of chips.

As a non-transitory computer-readable storage medium, the memory 42 can be used to store non-transitory software programs, non-transitory computer-executable programs and modules, such as corresponding program instructions/modules in the embodiments of the present application. The processor 41 executes various functional applications and data processing of the processor by running the non-transitory software programs, instructions and modules stored in the memory 42, so that the excitation small-current test methods in the above method embodiments are implemented.

The memory 42 may include a program storing region and a data storing region, wherein the program storing region may store an application program required for operating at least one function of the device; the data storing region can store the data created by the processor 41. Additionally, the memory 42 may include a high-speed random access memory, and may also include a non-transitory memory, such as at least one magnetic disk storage, flash memory device, or other non-transitory solid-state storage devices. In some embodiments, the memory 42 may optionally include memories located remotely from the processor 41, which may be connected to the processor 41 via the network. Examples of such networks include, but are not limited to, the Internet, the intranet, the local area network, the mobile communication network, and the combinations thereof.

The one or more modules are stored in the memory 42, which, when executed by the processor 41, execute the excitation small-current test method in the embodiment shown in FIG. 2.

The specific details of the above electronic device can be understood by referring to the corresponding description and effects in the embodiment shown in FIG. 2, details are not repeated here.

Although the embodiments of this application have been described with reference to the accompanying drawings, various modifications and variations can be made by those skilled in the art without departing from the scope of the present invention, as defined by the appended claims.

## Claims

1. An excitation circuit, comprising: a test power supply (4), an excitation small-current tester (3), a thyristor rectifier bridge (2) and an excitation regulator (1);

   one end of the excitation regulator (1) is connected to a first pin (21) of the thyristor rectifier bridge (2) for sending a synchronization signal to the thyristor rectifier bridge (2), and the synchronization signal is used for triggering a pulse signal of the thyristor rectifier bridge (2);
   the other end (12) of the excitation regulator (1) is connected to the excitation small-current tester (3) for receiving a Potential Transformer, PT, voltage signal sent by the excitation small-current tester (3), and the PT voltage signal is used for judging whether the excitation regulator (1) is operating normally;
   the test power supply (4) is connected to the excitation small-current tester (3) for outputting a voltage signal to the excitation small-current tester (3);
   the excitation small-current tester (3) comprises: a switch (QB), a voltage regulator (5), a current transformer (6), a voltage transformer (7), an industrial controller (8), an oscilloscope (9), a resistive load (10) and a shunt (11); wherein,
   a first pin (61) of the current transformer (6) is connected to a second pin (22) of the thyristor rectifier bridge (2) for receiving an anode three-phase current output from the thyristor rectifier bridge (2);

a first pin (71) of the voltage transformer (7) is connected through the current transformer (6) to the second pin (22) of the thyristor rectifier bridge (2) for receiving an anode three-phase voltage output from the thyristor rectifier bridge (2);

an input end (91) of the oscilloscope (9) is connected to a third pin (23) of the thyristor rectifier bridge (2) through the resistive load (10) and the shunt (11) for displaying an excitation current and an excitation voltage output from the thyristor rectifier bridge (2);

a first pin (81) of the industrial controller (8) is connected to a second pin (62) of the current transformer (6) for receiving the anode three-phase current sent by the current transformer (6);

a second pin (82) of the industrial controller (8) is connected to a second pin (72) of the voltage transformer (7) for receiving the anode three-phase voltage sent by the voltage transformer (7);

a third pin (83) of the industrial controller (8) is connected to an output end (92) of the oscilloscope (9) for receiving the excitation current and the excitation voltage sent by the oscilloscope (9).

2. The excitation circuit according to claim 1, **characterized in that** the other end (12) of the excitation regulator (1) is further connected to the second pin (22) of the thyristor rectifier bridge (2).

3. The excitation circuit according to claim 1, **characterized in that**,

a third pin (63) of the current transformer (6) is connected to the test power supply (4) through the voltage regulator (5) and the switch (QB);

the first pin (71) of the voltage transformer (7) is further connected to the test power supply (4) through the voltage regulator (5) and the switch (QB).

4. The excitation circuit according to claim 1, **characterized in that**,

the oscilloscope (9) is further configured to display a six-pulse waveform of the thyristor rectifier bridge (2);

the industrial controller (8) is further configured to display the six-pulse waveform of the thyristor rectifier bridge (2) sent by the oscilloscope (9);

the industrial controller (8) is further configured to display an output waveform of the thyristor rectifier bridge (2), and the output waveform comprises an anode three-phase voltage waveform, an excitation current waveform, an excitation voltage waveform and an anode three-phase current waveform.

5. An excitation small-current test method applied by the excitation circuit according to any one of claims 1 to 4, comprising:

Step 101: acquiring the anode three-phase voltage and the excitation voltage of the thyristor rectifier bridge (2) when the excitation small-current tester (3) receives the voltage signal output from the test power supply (4) and determines a first control angle of the excitation regulator (1), wherein the first control angle is used for controlling the thyristor rectifier bridge (2) to switch into conduction;

Step 102: calculating a second control angle of the thyristor rectifier bridge (2) by a preset algorithm based on the first control angle, the anode three-phase voltage and the excitation voltage, wherein the second control angle is a control angle of the thyristor rectifier bridge (2) when the excitation regulator (1) controls the thyristor rectifier bridge (2) to switch into conduction based on the first control angle, and the second control angle is used for controlling the thyristor rectifier bridge (2) to be kept in a rectifying state;

Step 103: analyzing the accuracy of the regulating performance of the excitation regulator (1) based on the first control angle and the second control angle.

6. The method according to claim 5, **characterized by** further comprising:

acquiring the anode three-phase current and the excitation current of the thyristor rectifier bridge (2) when the excitation small-current tester (3) receives the voltage signal output from the test power supply (4) and determines the first control angle of the excitation regulator (1);

generating an excitation small-current test report based on the anode three-phase voltage, the excitation voltage, the anode three-phase current and the excitation current.

7. The method according to claim 6, **characterized by** further comprising:
calling a preset knowledge base for diagnosis to obtain a first diagnosis result when a six-pulse waveform of the thyristor rectifier bridge (2) is displayed incompletely, wherein the first diagnosis result comprises one or more of an abnormality of a thyristor of the thyristor rectifier bridge (2), an abnormality of a pulse trigger signal of the thyristor rectifier bridge (2), and an abnormality of a pulse transformer of the thyristor rectifier bridge (2), and the preset knowledge base comprises a voltage calculation method, a current calculation method, expert knowledge, and a logic judgment method.

8.  The method according to claim 6, **characterized by** further comprising:
    calling a preset knowledge base for diagnosis to obtain a second diagnosis result when an output waveform of the thyristor rectifier bridge (2) is abnormally displayed or not displayed, wherein the second diagnosis result comprises one or more of a wiring phase sequence error of the test power supply (4), an abnormality of the test power supply (4), and an insufficient capacity of the test power supply (4).

9.  The method according to claim 6, **characterized by** further comprising:
    calling a preset knowledge base for diagnosis to obtain a third diagnosis result when the first control angle is inconsistent with the second control angle, wherein the third diagnosis result is that a sampling signal of a synchronous transformer in the excitation regulator (1) is inconsistent with actual working wiring.

10. An electronic device, comprising: a memory (42) and a processor (41), wherein the memory (42) and the processor (41) are connected in communication with each other, the memory (42) stores computer instructions, and the processor (41) is configured to execute the excitation small-current test method according to any one of claims 5 to 9 by executing the computer instructions.


**Patentansprüche**

1.  Erregungsschaltung, umfassend: eine Prüfstromversorgung (4), ein Schwachstrom-Erregungstestgerät (3), eine Thyristor-Gleichrichterbrücke (2) und einen Erregungsregler (1);

    wobei ein Ende des Erregungsreglers (1) mit einem ersten Anschluss (21) der Thyristor-Gleichrichterbrücke (2) verbunden ist, um ein Synchronisationssignal an die Thyristor-Gleichrichterbrücke (2) zu senden, wobei das Synchronisationssignal zum Auslösen eines Impulssignals der Thyristor-Gleichrichterbrücke (2) verwendet wird;
    wobei das andere Ende (12) des Erregungsreglers (1) mit dem Schwachstrom-Erregungstestgerät (3) verbunden ist, um ein von dem Schwachstrom-Erregungstestgerät (3) gesendetes PT-Spannungssignal zu empfangen, wobei das PT-Spannungssignal zum Beurteilen verwendet wird, ob der Erregungsregler (1) normal arbeitet;
    wobei die Prüfstromversorgung (4) mit dem Schwachstrom-Erregungstestgerät (3) verbunden ist, um ein Spannungssignal an das Schwachstrom-Erregungstestgerät (3) auszugeben;
    wobei das Schwachstrom-Erregungstestgerät (3) umfasst: einen Schalter (QB), einen Spannungsregler (5), einen Stromwandler (6), einen Spannungswandler (7), eine Industriesteuerung (8), ein Oszilloskop (9), eine ohmsche Last (10) und einen Shunt (11);
    wobei ein erster Anschluss (61) des Stromwandlers (6) mit einem zweiten Anschluss (22) der Thyristor-Gleichrichterbrücke (2) verbunden ist, um einen von der Thyristor-Gleichrichterbrücke (2) ausgegebenen anodenseitigen Dreiphasenstrom zu empfangen;
    wobei ein erster Anschluss (71) des Spannungswandlers (7) über den Stromwandler (6) mit dem zweiten Anschluss (22) der Thyristor-Gleichrichterbrücke (2) verbunden ist, um eine von der Thyristor-Gleichrichterbrücke (2) ausgegebene anodenseitige Dreiphasenspannung zu empfangen;
    wobei ein Eingang (91) des Oszilloskops (9) über die ohmsche Last (10) und den Shunt (11) mit einem dritten Anschluss (23) der Thyristor-Gleichrichterbrücke (2) verbunden ist, um einen von der Thyristor-Gleichrichterbrücke (2) ausgegebenen Erregerstrom und eine von der Thyristor-Gleichrichterbrücke (2) ausgegebene Erregerspannung anzuzeigen;
    wobei ein erster Anschluss (81) der Industriesteuerung (8) mit einem zweiten Anschluss (62) des Stromwandlers (6) verbunden ist, um den von dem Stromwandler (6) gesendeten anodenseitigen Dreiphasenstrom zu empfangen;
    wobei ein zweiter Anschluss (82) der Industriesteuerung (8) mit einem zweiten Anschluss (72) des Spannungswandlers (7) verbunden ist, um die von dem Spannungswandler (7) gesendete anodenseitige Dreiphasenspannung zu empfangen;
    und wobei ein dritter Anschluss (83) der Industriesteuerung (8) mit einem Ausgang (92) des Oszilloskops (9) verbunden ist, um den von dem Oszilloskop (9) gesendeten Erregerstrom und die von dem Oszilloskop (9) gesendete Erregerspannung zu empfangen.

2. Erregungsschaltung nach Anspruch 1, **dadurch gekennzeichnet, dass** das andere Ende (12) des Erregungsreglers (1) ferner mit dem zweiten Anschluss (22) der Thyristor-Gleichrichterbrücke (2) verbunden ist.

3. Erregungsschaltung nach Anspruch 1, **dadurch gekennzeichnet, dass** ein dritter Anschluss (63) des Stromwandlers (6) über den Spannungsregler (5) und den Schalter (QB) mit der Prüfstromversorgung (4) verbunden ist; dass der erste Anschluss (71) des Spannungswandlers (7) ferner über den Spannungsregler (5) und den Schalter (QB) mit der Prüfstromversorgung (4) verbunden ist.

4. Erregungsschaltung nach Anspruch 1, **dadurch gekennzeichnet, dass** das Oszilloskop (9) ferner dazu ausgebildet ist, eine Sechspulswellenform der Thyristor-Gleichrichterbrücke (2) anzuzeigen;

dass die Industriesteuerung (8) ferner dazu ausgebildet ist, die von dem Oszilloskop (9) gesendete Sechspulswellenform der Thyristor-Gleichrichterbrücke (2) anzuzeigen;
dass die Industriesteuerung (8) ferner dazu ausgebildet ist, eine Ausgangswellenform der Thyristor-Gleichrichterbrücke (2) anzuzeigen, wobei die Ausgangswellenform eine Wellenform einer anodenseitigen Dreiphasenspannung, eine Erregerstromwellenform, eine Erregerspannungswellenform und eine Wellenform eines anodenseitigen Dreiphasenstroms umfasst.

5. Schwachstrom-Erregungstestverfahren, das bei der Erregungsschaltung nach einem der Ansprüche 1 bis 4 angewendet wird, umfassend:

Schritt 101: Erfassen der anodenseitigen Dreiphasenspannung und der Erregerspannung der Thyristor-Gleichrichterbrücke (2), wenn das Schwachstrom-Erregungstestgerät (3) das von der Prüfstromversorgung (4) ausgegebene Spannungssignal empfängt und einen ersten Steuerwinkel des Erregungsreglers (1) bestimmt, wobei der erste Steuerwinkel dazu verwendet wird, die Thyristor-Gleichrichterbrücke (2) in den leitenden Zustand zu schalten;
Schritt 102: Berechnen eines zweiten Steuerwinkels der Thyristor-Gleichrichterbrücke (2) mittels eines vorgegebenen Algorithmus basierend auf dem ersten Steuerwinkel, der anodenseitigen Dreiphasenspannung und der Erregerspannung, wobei der zweite Steuerwinkel ein Steuerwinkel der Thyristor-Gleichrichterbrücke (2) ist, wenn der Erregungsregler (1) die Thyristor-Gleichrichterbrücke (2) basierend auf dem ersten Steuerwinkel in den leitenden Zustand schaltet, und wobei der zweite Steuerwinkel dazu verwendet wird, die Thyristor-Gleichrichterbrücke (2) in einem Gleichrichtzustand zu halten;
Schritt 103: Analysieren der Genauigkeit des Regelverhaltens des Erregungsreglers (1) basierend auf dem ersten Steuerwinkel und dem zweiten Steuerwinkel.

6. Verfahren nach Anspruch 5, **dadurch gekennzeichnet, dass** es ferner umfasst:

Erfassen des anodenseitigen Dreiphasenstroms und des Erregerstroms der Thyristor-Gleichrichterbrücke (2), wenn das Schwachstrom-Erregungstestgerät (3) das von der Prüfstromversorgung (4) ausgegebene Spannungssignal empfängt und den ersten Steuerwinkel des Erregungsreglers (1) bestimmt;
Erzeugen eines Schwachstrom-Erregungstestberichts basierend auf der anodenseitigen Dreiphasenspannung, der Erregerspannung, dem anodenseitigen Dreiphasenstrom und dem Erregerstrom.

7. Verfahren nach Anspruch 6, **dadurch gekennzeichnet, dass** es ferner umfasst: Aufrufen einer vorgegebenen Wissensdatenbank zur Diagnose, um ein erstes Diagnoseergebnis zu erhalten, wenn eine Sechspulswellenform der Thyristor-Gleichrichterbrücke (2) unvollständig angezeigt wird, wobei das erste Diagnoseergebnis eines oder mehrere aus einer Abnormalität eines Thyristors der Thyristor-Gleichrichterbrücke (2), einer Abnormalität eines Impulszündsignals der Thyristor-Gleichrichterbrücke (2) und einer Abnormalität eines Impulstransformators der Thyristor-Gleichrichterbrücke (2) umfasst, und wobei die vorgegebene Wissensdatenbank ein Spannungsberechnungsverfahren, ein Stromberechnungsverfahren, Expertenwissen und ein logisches Beurteilungsverfahren umfasst.

8. Verfahren nach Anspruch 6, **dadurch gekennzeichnet, dass** es ferner umfasst:
Aufrufen einer vorgegebenen Wissensdatenbank zur Diagnose, um ein zweites Diagnoseergebnis zu erhalten, wenn eine Ausgangswellenform der Thyristor-Gleichrichterbrücke (2) abnormal angezeigt wird oder nicht angezeigt wird, wobei das zweite Diagnoseergebnis eines oder mehrere aus einem Fehler in der Phasenfolge der Verdrahtung der Prüfstromversorgung (4), einer Abnormalität der Prüfstromversorgung (4) und einer unzureichenden Kapazität der Prüfstromversorgung (4) umfasst.

9. Verfahren nach Anspruch 6, **dadurch gekennzeichnet, dass** es ferner umfasst:
Aufrufen einer vorgegebenen Wissensdatenbank zur Diagnose, um ein drittes Diagnoseergebnis zu erhalten, wenn der erste Steuerwinkel mit dem zweiten Steuerwinkel nicht übereinstimmt, wobei das dritte Diagnoseergebnis darin besteht, dass ein Abtastsignal eines Synchrontransformators in dem Erregungsregler (1) mit einer tatsächlichen Betriebsverdrahtung nicht übereinstimmt.

10. Elektronische Vorrichtung, umfassend: einen Speicher (42) und einen Prozessor (41), wobei der Speicher (42) und der Prozessor (41) kommunikationstechnisch miteinander verbunden sind, und wobei der Speicher (42) Computeranweisungen speichert, und wobei der Prozessor (41) dazu ausgebildet ist, durch Ausführen der Computeranweisungen das Schwachstrom-Erregungstestverfahren nach einem der Ansprüche 5 bis 9 auszuführen.

## Revendications

1. Un circuit d'excitation, comprenant : une alimentation électrique de test (4), un testeur de faible courant d'excitation (3), un pont redresseur de thyristor (2) et un régulateur d'excitation (1) ;

   une extrémité du régulateur d'excitation (1) est raccordée à une première broche (21) du pont redresseur de thyristor (2) pour envoyer un signal de synchronisation au pont redresseur de thyristor (2), et le signal de synchronisation est utilisé pour déclencher un signal d'impulsion du pont redresseur de thyristor (2) ;
   l'autre extrémité (12) du régulateur d'excitation (1) est raccordée au testeur de faible courant d'excitation (3) pour recevoir un signal de tension de transformateur de potentiel PT envoyé par le testeur de faible courant d'excitation (3), et le signal de tension du PT sert à juger si le régulateur d'excitation (1) fonctionne normalement ;
   l'alimentation électrique de test (4) est raccordée au testeur de faible courant d'excitation (3) pour envoyer un signal de tension au testeur de faible courant d'excitation (3) ;
   le testeur de faible courant d'excitation (3) comprend : un interrupteur (QB), un régulateur de tension (5), un transformateur de courant (6), un transformateur de tension (7), un contrôleur industriel (8), un oscilloscope (9), une charge résistive (10) et un shunt (11) ; dans lequel
   une première broche (61) du transformateur de courant (6) est raccordée à une deuxième broche (22) du pont redresseur de thyristor (2) pour recevoir un courant triphasé d'anode provenant du pont redresseur de thyristor (2) ;
   une première broche (71) du transformateur de tension (7) est raccordée via le transformateur de courant (6) à la deuxième broche (22) du pont redresseur de thyristor (2) pour recevoir une sortie de tension triphasée d'anode provenant du pont redresseur de thyristor (2) ;
   une extrémité d'entrée (91) de l'oscilloscope (9) est raccordée à une troisième broche (23) du pont redresseur de thyristor (2) via la charge résistive (10) et le shunt (11) pour afficher un courant d'excitation et une tension d'excitation sortie du pont redresseur de thyristor (2) ;
   une première broche (81) du contrôleur industriel (8) est raccordée à une deuxième broche (62) du transformateur de courant (6) pour recevoir le courant triphasé d'anode envoyé par le transformateur de courant (6) ;
   une deuxième broche (82) du contrôleur industriel (8) est raccordée à une deuxième broche (72) du transformateur de tension (7) pour recevoir la tension triphasée de l'anode envoyée par le transformateur de tension (7) ;
   une troisième broche (83) du contrôleur industriel (8) est raccordée à une extrémité de sortie (92) de l'oscilloscope (9) pour recevoir le courant d'excitation et la tension d'excitation envoyée par l'oscilloscope (9).

2. Circuit d'excitation selon la revendication 1, caractérisé en ce sens que l'autre extrémité (12) du régulateur d'excitation (1) est en outre raccordée à la deuxième broche (22) du pont redresseur de thyristor (2).

3. Circuit d'excitation selon la revendication 1, caractérisé en que :

   une troisième broche (63) du transformateur de courant (6) est raccordée à l'alimentation de test (4) via le régulateur de tension (5) et l'interrupteur (QB) ;
   la première broche (71) du transformateur de tension (7) est également raccordée à l'alimentation électrique de test (4) via le régulateur de tension (5) et l'interrupteur (QB).

**4.** Circuit d'excitation selon la revendication 1, caractérisé en que :

l'oscilloscope (9) est en outre configuré pour afficher une forme d'onde à six impulsions du pont redresseur de thyristor (2) ;

le contrôleur industriel (8) est également configuré pour afficher la forme d'onde à six impulsions du pont redresseur de thyristor (2) envoyée par l'oscilloscope (9) ;

le contrôleur industriel (8) est également configuré pour afficher une forme d'onde de sortie du pont redresseur de thyristor (2), et la forme d'onde de sortie comprend une forme d'onde de tension triphasée à anode, une forme d'onde de courant d'excitation, une forme d'onde de tension d'excitation et une forme d'onde de courant triphasé à anode.

**5.** Procédé de test à faible courant d'excitation appliqué par le circuit d'excitation selon l'une des revendications 1 à 4, comprenant :

Étape 101 : acquisition de la tension triphasée d'anode et de la tension d'excitation du pont redresseur de thyristor (2) lorsque le testeur de faible courant d'excitation (3) reçoit le signal de tension produit par l'alimentation électrique de test (4) et détermine un premier angle de commande du régulateur d'excitation (1), où le premier angle de commande est utilisé pour contrôler le pont redresseur de thyristor (2) pour passer à la conduction ;

Étape 102 : calculer un deuxième angle de commande du pont redresseur de thyristor (2) par un algorithme prédéfini basé sur le premier angle de commande, la tension triphasée de l'anode et la tension d'excitation, le deuxième angle de commande étant un angle de commande du pont redresseur de thyristor (2) lorsque le régulateur d'excitation (1) contrôle le pont redresseur de thyristor (2) pour passer en conduction selon le premier angle de commande, et le deuxième angle de commande sert à contrôler le pont redresseur de thyristor (2) à être maintenu dans un état de redressement ;

Étape 103 : analyse de la précision de la performance de régulation du régulateur d'excitation (1) en fonction du premier angle de commande et du deuxième angle de commande.

**6.** Procédé selon la revendication 5, **caractérisé en ce qu'**il comprend en outre :

acquisition du courant triphasé d'anode et du courant d'excitation du pont redresseur de thyristor (2) lorsque le testeur de faible courant d'excitation (3) reçoit le signal de tension produit par l'alimentation électrique de test (4) et détermine le premier angle de commande du régulateur d'excitation (1) ;

génération d'un rapport de test à faible courant d'excitation basé sur la tension triphasée de l'anode, la tension d'excitation, le courant triphasé d'anode et le courant d'excitation.

**7.** Procédé selon la revendication 6, **caractérisé en ce qu'**il comprend en outre :
appel à une base de connaissances prédéfinie pour le diagnostic afin d'obtenir un résultat du premier diagnostic lorsqu'une forme d'onde à six impulsions du pont redresseur de thyristor (2) est affichée incomplètement, le premier résultat du diagnostic comprenant une ou plusieurs anomalies d'un thyristor du pont redresseur de thyristor (2), une anomalie d'un signal déclencheur d'impulsion du pont redresseur de thyristor (2), et une anomalie d'un transformateur d'impulsions du pont redresseur de thyristor (2), et la base de connaissances prédéfinie comprend un procédé de calcul de tension, un procédé de calcul de courant, des connaissances expertes et un procédé de jugement logique.

**8.** Procédé selon la revendication 6, **caractérisé en ce qu'**il comprend en outre :
appel à une base de connaissances prédéfinie pour le diagnostic afin d'obtenir un deuxième résultat de diagnostic lorsqu'une forme d'onde de sortie du pont redresseur de thyristor (2) est affichée de manière anormale ou non, le deuxième résultat de diagnostic comprenant une ou plusieurs d'une erreur de séquence de phase de câblage de l'alimentation de test (4), une anomalie de l'alimentation de test (4), et une capacité insuffisante de l'alimentation de test (4).

**9.** Procédé selon la revendication 6, **caractérisé en ce qu'**il comprend en outre :
appel à une base de connaissances prédéfinie pour le diagnostic afin d'obtenir un troisième résultat de diagnostic lorsque le premier angle de commande est incohérent avec le deuxième angle, dans lequel le troisième résultat de diagnostic est qu'un signal d'échantillonnage d'un transformateur synchrone dans le régulateur d'excitation (1) est incohérent avec le câblage fonctionnel réel.

**10.** Dispositif électronique, **caractérisé en ce qu'**il comprend : une mémoire (42) et un processeur (41), dans lequel la mémoire (42) et le processeur (41) sont raccordés en communication entre eux, la mémoire (42) stocke des instructions informatiques, et le processeur (41) est configuré pour exécuter le procédé de test d'excitation à faible courant selon l'une des revendications 5 à 9 en exécutant les instructions informatiques.

FIG. 1

Acquiring the anode three-phase voltage and the excitation voltage of the thyristor rectifier bridge when the excitation small-current tester receives the voltage signal output from the test power supply and determines the first control angle of the excitation regulator, wherein the first control angle is used for controlling the thyristor rectifier bridge to switch into conduction
101

Calculating the second control angle of the thyristor rectifier bridge by a preset algorithm based on the first control angle, the anode three-phase voltage and the excitation voltage, wherein the second control angle is a control angle of the thyristor rectifier bridge when the excitation regulator controls the thyristor rectifier bridge to switch into conduction based on the first control angle, and used to control the thyristor rectifier bridge to be kept in a rectifying state
102

Analyzing the accuracy of the regulating performance of the excitation regulator based on the first control angle and the second control angle
103

FIG. 2

Computer Readable Storage Medium

Computer Program

301

FIG. 3

Processor

41

Memory

42

FIG. 4

**EP 4 332 593 B1**

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- CN 214409220 U
- CN 214375065 U
- CN 209764962 U
- CN 109581176 A
- CN 106814315 A

**Non-patent literature cited in the description**

- **ANDRIY KUTSYK et al.** Diagnosis of the Static Excitation Systems of Synchronous Generators with the Use of Hardware-In-the-Loop Technologies. *Energies*, 2021, vol. 14, 6937